# EUROPÄISCHE PATENTSCHRIFT

(11) **EP 4 602 385 B1**
(45) Veröffentlichungstag und Bekanntmachung des Hinweises auf die Patenterteilung: **11.11.2026**
(21) Anmeldenummer: 23777193.6
(22) Anmeldetag: 25.09.2023
(51) Int. Cl.: G01R 31/367, G01R 31/392, G01R 31/3842, H01M 10/48

(54) **VERFAHREN UND VORRICHTUNG ZUM ABSCHÄTZEN EINER SELBSTENTLADERATE EINER BATTERIEZELLE IN DER BATTERIEZELLENFERTIGUNG**
METHOD AND DEVICE FOR ESTIMATING A SELF-DISCHARGE RATE OF A BATTERY CELL IN BATTERY CELL PRODUCTION
PROCÉDÉ ET DISPOSITIF D'ESTIMATION DE TAUX D'AUTODÉCHARGE D'UN ÉLÉMENT DE BATTERIE DANS LA PRODUCTION D'ÉLÉMENTS DE BATTERIE

(30) Priorität: 14.10.2022 DE 102022126834
(43) Veröffentlichungstag der Anmeldung: 20.08.2025
(73) Patentinhaber: VOLKSWAGEN AG, 38440 Wolfsburg (DE)
(72) Erfinder: ROHKOHL, Erik, 38300 Wolfenbüttel (DE); BUECKER, Thies, 38102 Braunschweig (DE); HOFFMANN, Louisa, 31275 Lehrte (DE); BODROV, Yury, 38159 Vechelde (DE)
(74) Vertreter: Gulde & Partner
(86) Internationale Anmeldenummer: PCT/EP2023/076327
(87) Internationale Veröffentlichungsnummer: WO 2024/078850

(56) Entgegenhaltungen:
- CN-A- 113 359 048
- CN-A- 115 166 566
- KR-B1- 102 035 675
- US-A1- 2019 033 385
- US-B1- 10 522 881

## Beschreibung

Die Erfindung betrifft ein Verfahren zum Abschätzen einer Selbstentladerate einer Batteriezelle in der Batteriezellenfertigung und eine Vorrichtung zum Abschätzen einer Selbstentladerate einer Batteriezelle in der Batteriezellenfertigung.

Die Batteriezellenfertigung lässt sich im Wesentlichen in die Bereiche Elektrodenherstellung, mechanischer Zellbau und Konditionierung aufteilen. Bei der Konditionierung durchlaufen die mechanisch zusammengebauten Batteriezellen in der Regel die Prozessschritte Formation, End-of-Line-Test und Reifelagerung. In der Formation wird die mechanisch zusammengebaute Batteriezelle erstmalig elektrisch aktiviert und die für die Funktion der Batteriezelle relevanten Deckschichten bilden sich mittels chemisch irreversibler Prozesse auf den Elektroden aus. Mit dem End-of-Line-Test wird die elektrochemische Qualität der Batteriezelle überprüft. In der anschließenden Reifelagerung, die dem Zweck der Bestimmung einer Selbstentladerate der Batteriezelle dient, wird die Batteriezelle auf eine vordefinierte Spannung geladen und die Spannungsdifferenz nach Ablauf einer vorgegebenen Prüfzeit, beispielsweise einer 14- bis 21-tägigen Lagerung, gemessen. Ein so festgestellter signifikanter Spannungsabfall deutet auf unerwünschte Defekte in der Batteriezelle hin. Derartige unerwünschte Defekte können ein Sicherheitsrisiko darstellen, beispielsweise aufgrund eines punktuellen Dendritenwachstums an der negativen Elektrode der Batteriezelle. Insbesondere, wenn die Dendriten die Gegenelektrode erreichen, können diese im Zusammenspiel mit entflammbaren Elektrolyten einen Kurzschluss der Batteriezelle verursachen, die zu einem Abbrennen Batteriezelle führen können. Ferner beeinflusst eine zu hohe Selbstentladungsrate der Batteriezelle deren Qualität und Eigenschaften. So ist der durch eine hohe Selbstentladungsrate verursachte Spannungsverlust merklich spürbar, wenn die Batteriezelle im geladenen Zustand eine längere Zeit ungenutzt bleibt, beispielsweise in einem länger geparkten Elektrofahrzeug. In der Folge steht dem Fahrer des Fahrzeugs eine geringere effektive Reichweite zur Verfügung.

Dokument US 10,522,881 B1 beschreibt ein Verfahren zur Abschätzung und Überwachung einer Selbstentladungsrate zur Verwendung als Maß für den Batteriezustand. Hierzui werden eine Vielzahl von Momentaufnahmen empfangen, die durch Überwachung eines Batteriesystems im Ruhezustand zu einer Vielzahl von Zeitpunkten gewonnen werden. Jede Momentaufnahme enthält eine Mehrzahl von Zellstatuswerten zu einem der Mehrzahl von Zeitpunkten. Dann wird ein Selbstentladungsindikator unter Verwendung mindestens einer Momentaufnahme der Vielzahl von Momentaufnahmen abgeschätzt, der Selbstentladungsindikator mit einem Schwellenwert verglichen und in Reaktion darauf, dass der Selbstentladungsindikator den Schwellenwert überschreitet, eine Abhilfemaßnahme für das Batteriesystem empfohlen.

Dokument CN 113359048 A beschreibt ein indirektes Vorhersageverfahren für die Restlebensdauer einer Lithium-Ionen-Batterie.

Die Reifelagerung von Batteriezellen in der Batteriezellenfertigung ist für die Qualitätssicherung wichtig. Allerdings wird dadurch auch die Fertigungszeit der Batteriezelle erheblich gesteigert und es treten hohe Lagerkosten auf. Insgesamt bindet die Reifelagerung viel Kapital in der Batteriezellenfertigung.

Der Erfindung liegt daher die Aufgabe zugrunde, die Produktionszeiten und -kosten der Batteriezellenfertigung zu verringern.

Die erfindungsgemäße Aufgabe wird gelöst durch ein Verfahren und eine Vorrichtung zum Abschätzen einer Selbstentladerate einer Batteriezelle in der Batteriezellenfertigung gemäß den unabhängigen Ansprüchen. Bevorzugte Weiterbildungen sind Gegenstand der jeweils rückbezogenen Unteransprüche.

Ein erster Aspekt betrifft ein Verfahren zum Abschätzen einer Selbstentladerate einer Batteriezelle in der Batteriezellenfertigung. In einem Schritt wird ein Strom-Spannung-Formationsprofil einer Batteriezelle während des Formationsprozesses der Batteriezelle in der Batteriezellenfertigung aufgenommen. Das Strom-Spannung-Formationsprofil der Batteriezelle ist indikativ für eine in der Batteriezelle auftretende Stromstärke bei einer an der Batteriezelle angelegten Spannung und/oder für eine in der Batteriezelle auftretenden Spannung bei einer an der Batteriezelle angelegten Stromstärke. Mit anderen Worten umfasst das Strom-Spannung-Formationsprofil Stromstärken- und Spannungs-Kennlinien der Batteriezelle im zeitlichen Verlauf. Im Formationsprozess wird zwischen einer angelegten konstanten Spannung und einer angelegten konstanten Stromstärke gewechselt, um verschiedene für die Formation der Batteriezelle erforderliche chemische Prozessabläufe zu fördern und in dem Strom-Spannung-Formationsprofil der Batteriezelle sichtbar zu machen. Das Strom-Spannungs-Formationsprofil umfasst folglich individuelle Informationen über die bei der Formation ablaufende Prozesse der Batteriezelle.

In einem weiteren Schritt wird eine Selbstentladerate der Batteriezelle unter Verwendung des Strom-Spannung-Formationsprofils der Batteriezelle und einer Vielzahl von Strom-Spannung-Formationsprofilen und korrespondierenden Selbstentladeraten oder Selbstentladungs-Profilen einer Vielzahl von Batteriezellen aus der Batteriezellenfertigung bestimmt. Die Selbstentladungsrate ergibt sich aus einer Spannungsdifferenz der Batteriezelle zwischen einem Zeitpunkt, in welchem die Batteriezelle mit einer vordefinierten Spannung geladen ist, und einem vorgegebenen späteren Zeitpunkt, beispielsweise, wie für die Reifelagerung üblich, nach 14 bis 21 Tagen, an welchem die Spannung der Batteriezelle erneut gemessen wird. Das Selbstentladungs-Profil umfasst bevorzugt eine Kennlinie der Selbstentladungsrate der Batteriezelle im zeitlichen Verlauf. Durch die Verknüpfung (Korrespondieren) eines Strom-Spannungs-Formationsprofils und einer Selbstentladerate oder eines Selbstentladungs-Profils einer Batteriezelle können Rückschlüsse auf die Qualität oder Güte der Batteriezelle gezogen werden. Unter Verwendung eines Selbstentladungsratenschwellenwertes kann eine Art Kategorisierung der Batteriezellen vorgenommen werden. Anhand der den Selbstentladeraten zugeordneten Strom-Spannungs-Formationsprofilen der Vielzahl von Batteriezellen lässt sich eine derartige Kategorisierung auf die Strom-Spannungs-Formationsprofile übertragen. Folglich können Batteriezellen, deren Selbstentladerate oder Selbstentlade-Profil noch nicht bestimmt wurde, mittels Vergleich der zugehörigen Strom-Spannungs-Formationsprofile mit den Strom-Spannungs-Formationsprofilen der Vielzahl von Batteriezellen kategorisiert werden. Mit anderen Worten kann erfindungsgemäß eine Selbstentladerate oder ein Selbstentlade-Profil einer Batteriezelle aus ihrem aufgenommenen Strom-Spannungs-Formationsprofil vorhergesagt werden, ohne, dass eine Bestimmung der Selbstentladerate mittels Reifelagerung für diese Batteriezelle erfolgen muss.

Verständlich ist, dass mit steigender Anzahl der Vielzahl von Batteriezellen und den zugehörigen Strom-Spannungs-Formationsprofilen und korrespondierenden Selbstentladeraten und/oder Selbstentladungs-Profilen auch eine Vorhersagequalität der erfindungsgemäß bestimmten oder abgeschätzten Selbstentladungsrate verbessert werden kann. Eine hohe Vorhersagequalität ist für die Wirtschaftlichkeit und die Qualitätssicherung wichtig, um nicht fälschlicherweise intakte Batteriezellen auszusortieren oder nicht intakte Batteriezellen nicht auszusortieren.

Gegenüber der Bestimmung des Selbstentlade-Profils erfordert die Bestimmung der Selbstentladerate zu einem vorgegebenen Zeitpunkt weniger Rechenleistung, während die Bestimmung des Selbstentlade-Profils eine größere Informationsdichte umfasst, die für eine weitere Auswertung, wie einer Fehleranalyse, zur Verfügung steht.

Bevorzugt wird die Batteriezelle aussortiert, wenn die zugehörige bestimmte Selbstentladerate einer vorgegebenen Selbstentladerate nicht entspricht, insbesondere den vorgegebenen Selbstentladeratenschwellenwert nicht unterschreitet, mithin eine zu hohe Selbstentladerate aufweist. Hierdurch können defekte oder fehlerhafte Batteriezellen vorzeitig aus dem Wertstrom der Prozesskette der Batteriezellenfertigung entfernt werden, wodurch sich Kostenersparnisse in der Produktion von Batteriezellen ergeben.

In bevorzugter Ausgestaltung ist vorgesehen, dass ferner ein Strom-Spannung-End-of-Life-Profil der Batteriezelle während eines End-of-Line-Tests in der Batteriezellenfertigung aufgenommen wird. Die Selbstentladerate der Batteriezelle wird hierbei ferner unter Verwendung des Strom-Spannung-End-of-Life-Profils der Batteriezelle und einer Vielzahl von Strom-Spannung-End-of-Life-Profilen der Vielzahl von Batteriezellen aus der Batteriezellenfertigung bestimmt. In dem Strom-Spannung-End-of-Line-Profil sind weitere Informationen über die individuelle Batteriezelle enthalten, welche beispielsweise auf Auffälligkeiten und Muster hin untersucht und mit den korrespondierenden Selbstentladeraten oder -profilen in Verbindung gebracht werden können. Folglich steht hiermit eine größere Datenmenge zur Bestimmung der Selbstentladerate der Batteriezelle zur Verfügung, sodass die Genauigkeit der Vorhersage oder Abschätzung der Selbstentladerate verbessert wird.

In weiterer bevorzugter Ausgestaltung ist vorgesehen, dass die Selbstentladerate der Batteriezelle unter Verwendung eines neuronalen Netzwerks bestimmt wird. Das neuronale Netzwerk ist mittels Trainingsdaten trainiert. Die Trainingsdaten umfassen hierbei mindestens einen Teil, bevorzugt die vollständige Vielzahl von Strom-Spannung-Formationsprofilen, Strom-Spannung-End-of-Life-Profilen und/oder korrespondierenden Selbstentladeraten der Vielzahl von Batteriezellen aus der Batteriezellenfertigung. Ein mit einem Mindestmaß trainiertes neuronales Netzwerk ist in der Lage, kleinste sich wiederholende Muster in den Strom-Spannung-Formationsprofilen, Strom-Spannung-End-of-Life-Profilen und den korrespondierenden Selbstentladeraten der Vielzahl von Batteriezellen zu erkennen, anhand derer sich mittels Rückwärtspropagierung (Backpropagation) Rückschlüsse über die Selbstentladerate ziehen lassen. Mit anderen Worten ist das trainierte neuronale Netzwerk dazu eingerichtet, Auffälligkeiten und Muster in den Trainingsdaten zu erkennen und diese jeweiligen Selbstentladeraten zuzuordnen. Verständlich ist, dass je mehr Trainingsdaten vorliegen, desto besser kann das neuronale Netzwerk trainiert werden, um die Vorhersagequalität der durch das neuronale Netzwerk bestimmten Selbstentladungsrate der Batteriezelle zu verbessern.

In weiterer bevorzugter Ausgestaltung ist vorgesehen, dass ein Abschätzungsfehler zu der bestimmten Selbstentladerate der Batteriezelle ermittelt wird und basierend auf dem ermittelten Abschätzungsfehler das Bestimmen der Selbstentladerate der Batteriezelle ferner unter Verwendung eines zusätzlichen Prozessparameters der Batteriezelle erneut erfolgt. Bevorzugt wird ein Abschätzungsfehler der erneuten Bestimmung bestimmt. Ist dieser noch immer unzureichend, so kann das Bestimmen der Selbstentladerate der Batteriezelle ferner unter Verwendung eines weiteren zusätzlichen Prozessparameters erfolgen und so weiter. Der Prozessparameter umfasst bevorzugt eine Zwischenprodukteigenschaft der Batteriezelle, vorzugsweise eines von einem Flächengewicht der Elektrodenbeschichtung nach dem Kalandrieren, einen Innenwiderstand der Batteriezelle zu verschiedenen Ladungszuständen, relative Anteile von Aktivmaterialien und Additiven in dem zur Herstellung der Elektroden verwendeten Slurry-Gemisch, ein Feuchtigkeitsgehalt der Elektroden (zum Beispiel nach der Beschichtung oder vor der Elektrolytbefüllung) und ein Gewicht des befüllten Elektrolyts. Der Abschätzungsfehler ist bevorzugt hinreichend, wenn das Intervall der bestimmten Selbstentladerate inklusive des Abschätzungsfehlers den vorgegebenen Selbstentladungsratenschwellenwert nicht umfasst und andersherum unzureichend, wenn der vorgegebene Selbstentladungsratenschwellenwert vom Intervall der bestimmten Selbstentladerate inklusive des Abschätzungsfehlers umfasst ist.

In weiterer bevorzugter Ausgestaltung ist vorgesehen, dass ferner ein Selbstentladungs-Profil der Batteriezelle während eines Reifelagerungsprozesses in der Batteriezellenfertigung aufgenommen wird. Das Bestimmen der Selbstentladerate der Batteriezelle erfolgt dann ferner unter Verwendung des Selbstentladungs-Profils der Batteriezelle und einer Vielzahl von Selbstentladungs-Profilen der Vielzahl von Batteriezellen aus der Batteriezellenfertigung. Durch die zusätzliche Verwendung von messtechnisch bestimmten Selbstentladeprofilen zur Bestimmung der Selbstladerate wird die Vorhersagequalität verbessert. Bevorzugt wird ein Zeitraum des Selbstentladungs-Profils so gewählt, dass dieser zwischen dem Zeitpunkt, in welchem die Batteriezelle mit einer vordefinierten Spannung geladen ist, und dem vorgegebenen späteren Zeitpunkt, beispielsweise, wie für die Reifelagerung üblich, nach 14 bis 21 Tagen, an welchem die Spannung der Batteriezelle erneut gemessen wird, um die Selbstladerate zu bestimmen, liegt. Mit anderen Worten wird das Selbstentladungs-Profil über einen kleineren Zeitraum aufgenommen, als bei der regulär vorgesehenen Reifelagerung.

Dadurch kann zumindest die zur Bestimmung der Selbstentladerate der Batteriezelle notwendige Dauer der Reifelagerung verkürzt werden.

Ein weiterer Aspekt betrifft eine Vorrichtung zum Abschätzen einer Selbstentladerate einer Batteriezelle aus der Batteriezellenfertigung. Die Vorrichtung umfasst eine Sensoreinheit, eine Speichereinheit und eine Steuereinheit. Die Sensoreinheit ist zum Aufnehmen eines Strom-Spannung-Formationsprofils einer Batteriezelle während eines Formationsprozesses in der Batteriezellenfertigung eingerichtet. Entsprechende Sensoreinheiten sind dem Fachmann hinlänglich bekannt und werden an dieser Stelle nicht näher erläutert. Die Speichereinheit umfasst beziehungsweise in der Speichereinheit hinterlegt sind eine Vielzahl von Strom-Spannung-Formationsprofilen und korrespondierenden Selbstentladeraten oder Selbstentladungs-Profilen einer Vielzahl von Batteriezellen aus der Batteriezellenfertigung. Die Steuereinheit ist dazu eingerichtet, eine Selbstentladerate der Batteriezelle unter Verwendung des Strom-Spannung-Formationsprofils der Batteriezelle und der in der Speichereinheit hinterlegten Vielzahl von Strom-Spannung-Formationsprofilen und korrespondierenden Selbstentladeraten oder Selbstentladungs-Profilen der Vielzahl von Batteriezellen aus der Batteriezellenfertigung zu bestimmen. Für die Vorrichtung ergeben sich die gleichen Vorteile wie die für das Verfahren beschriebenen Vorteile. Auf eine wiederholende Beschreibung wird daher verzichtet. Auch die als optional gekennzeichneten Merkmale sind sowohl für das Verfahren als auch für die Vorrichtung analog anwendbar.

In bevorzugter Ausgestaltung ist vorgesehen, dass die Sensoreinheit und/oder eine weitere Sensoreinheit, zum Aufnehmen eines Strom-Spannung-End-of-Life-Profils der Batteriezelle während eines End-of-Line-Tests in der Batteriezellenfertigung eingerichtet ist. Ferner sind in der Speichereinheit eine Vielzahl von Strom-Spannung-End-of-Life-Profilen der Vielzahl von Batteriezellen aus der Batteriezellenfertigung hinterlegt. Die Steuereinheit ist bevorzugt ferner dazu eingerichtet, die Selbstentladerate der Batteriezelle ferner unter Verwendung des Strom-Spannung-End-of-Life-Profils der Batteriezelle und der in der Speichereinheit hinterlegten Vielzahl von Strom-Spannung-End-of-Life-Profilen der Vielzahl von Batteriezellen aus der Batteriezellenfertigung zu bestimmen.

In weiterer bevorzugter Ausgestaltung ist vorgesehen, dass die Steuereinheit ein neuronales Netzwerk umfasst, welches mittels Trainingsdaten trainiert ist. Die Trainingsdaten umfassen hierbei mindestens einen Teil, bevorzugt die vollständige Vielzahl von Strom-Spannung-Formationsprofilen, Strom-Spannung-End-of-Life-Profilen und/oder korrespondierenden Selbstentladeraten der Vielzahl von Batteriezellen aus der Batteriezellenfertigung. Die Steuereinheit ist bevorzugt dazu eingerichtet, die Selbstentladerate der Batteriezelle unter Verwendung des neuronalen Netzwerks zu bestimmen.

In weiterer bevorzugter Ausgestaltung ist vorgesehen, dass die Steuereinheit ferner dazu eingerichtet ist, einen Abschätzungsfehler zu der bestimmten Selbstentladerate der Batteriezelle zu ermitteln und basierend auf dem ermittelten Abschätzungsfehler die Selbstentladerate der Batteriezelle ferner unter Verwendung eines zusätzlichen Prozessparameters der Batteriezelle erneut zu bestimmen.

In weiterer bevorzugter Ausgestaltung ist vorgesehen, dass die erste Sensoreinheit und/oder eine weitere Sensoreinheit zum Aufnehmen eines Selbstentladungs-Profils der Batteriezelle während eines Reifelagerungsprozesses in der Batteriezellenfertigung eingerichtet ist. Hierbei sind in der Speichereinheit ferner eine Vielzahl von Selbstentladungs-Profilen der Vielzahl von Batteriezellen aus der Batteriezellenfertigung hinterlegt. Die Steuereinheit ist ferner bevorzugt dazu eingerichtet, die Selbstentladerate der Batteriezelle ferner unter Verwendung des Selbstentladungs-Profils der Batteriezelle und der in der Speichereinheit hinterlegten Vielzahl von Selbstentladungs-Profilen der Vielzahl von Batteriezellen aus der Batteriezellenfertigung zu bestimmen.

Die oben genannte Steuereinheit ist bevorzugt durch elektrische oder elektronische Bauteile oder Komponenten (Hardware) oder durch Firmware (ASIC) implementiert. Zusätzlich oder alternativ wird die Funktionalität der Steuereinheit beim Ausführen eines geeigneten Programms (Software) verwirklicht. Ebenfalls bevorzugt ist die Steuereinheit durch eine Kombination von Hardware, Firmware und/oder Software verwirklicht. Beispielsweise sind einzelne Komponenten der Steuereinheit zum Bereitstellen einzelner Funktionalitäten als separat integrierter Schaltkreis ausgebildet oder auf einem gemeinsamen integrierten Schaltkreis angeordnet.

Die einzelnen Komponenten der Steuereinheit sind ferner bevorzugt als ein oder mehrere Prozesse ausgebildet, die auf einem oder mehreren Prozessoren in einem oder mehreren elektronischen Rechengeräten laufen und beim Ausführen von ein oder mehreren Computerprogrammen erzeugt werden. Die Rechengeräte sind dabei bevorzugt dazu ausgebildet, mit anderen Komponenten zusammenzuarbeiten, um die hierin beschriebenen Funktionalitäten zu verwirklichen. Die Anweisungen der Computerprogramme sind dabei bevorzugt in einem Speicher abgelegt, wie beispielsweise einem RAM-Element. Die Computerprogramme können jedoch auch in einem nicht-flüchtigen Speichermedium, wie beispielsweise einer CD-ROM, einem Flash-Speicher oder dergleichen, abgelegt sein.

Dem Fachmann ist ferner ersichtlich, dass die Funktionalitäten von mehreren Recheneinheiten (Datenverarbeitungsgeräten) kombiniert oder in einem einzigen Gerät kombiniert sein können oder dass die Funktionalität von einem bestimmten Datenverarbeitungsgerät auf eine Vielzahl von Geräten verteilt vorliegen kann, um die Funktionalität der Steuereinheit zu verwirklichen.

Ein weiterer Aspekt betrifft ein Computerprogramm, umfassend Befehle, die bei der Ausführung des Programms durch einen Computer, wie beispielsweise eine Steuereinheit einer Vorrichtung zum Abschätzen einer Selbstentladerate einer Batteriezelle aus der Batteriezellenfertigung aufweisend eine Sensoreinheit, die zum Aufnehmen eines Strom-Spannung-Formationsprofils einer Batteriezelle während eines Formationsprozesses in der Batteriezellenfertigung eingerichtet ist, und eine Speichereinheit, diesen veranlassen, das erfindungsgemäße Verfahren, insbesondere ein Verfahren zum Abschätzen einer Selbstentladerate einer Batteriezelle aus der Batteriezellenfertigung durchzuführen.

Weitere bevorzugte Ausgestaltungen der Erfindung ergeben sich aus den übrigen, in den Unteransprüchen genannten Merkmalen.

Die verschiedenen in dieser Anmeldung genannten Ausführungsformen der Erfindung sind, sofern im Einzelfall nicht anders ausgeführt, mit Vorteil miteinander kombinierbar.

Die Erfindung wird nachfolgend in Ausführungsbeispielen anhand der zugehörigen Zeichnungen erläutert. Es zeigen:
- Figur 1: eine schematische Darstellung eines Strom-Spannung-Formationsprofils einer Batteriezelle während eines Formationsprozesses;
- Figur 2: eine schematische Darstellung eines Strom-Spannung-End-of-Life-Profils der Batteriezelle während eines End-of-Line-Tests;
- Figur 3: eine schematische Darstellung von drei verschiedenen Selbstentladungs-Profilen von verschiedenen Batteriezellen während der Reifelagerung;
- Figur 4: eine schematische Darstellung einer Vorrichtung gemäß einer Ausführungsform; und
- Figur 5: eine schematische Darstellung eines Verfahrens gemäß einer Durchführungsform.

Die Kenntnis über eine Vielzahl von Strom-Spannung-Formationsprofilen und zugehörigen Selbstentladungs-Profilen von einer Vielzahl von Batteriezellen aus der Batteriezellenfertigung erlaubt es, eine Selbstentladungsrate einer zu überprüfenden Batteriezelle anhand ihres Strom-Spannung-Formationsprofils zu bestimmen, mithin vorherzusagen. Im einfachsten Fall ist dies ohne Durchführung einer Reifelagerung der zu überprüfenden Batteriezelle möglich. Durch die zusätzliche Kenntnis über eine Vielzahl von Strom-Spannung-End-of-Life-Profilen der Vielzahl von Batteriezellen aus der Batteriezellenfertigung kann eine Vorhersagequalität der Selbstentladerate verbessert werden. Dies wird im Einzelnen näher erläutert.

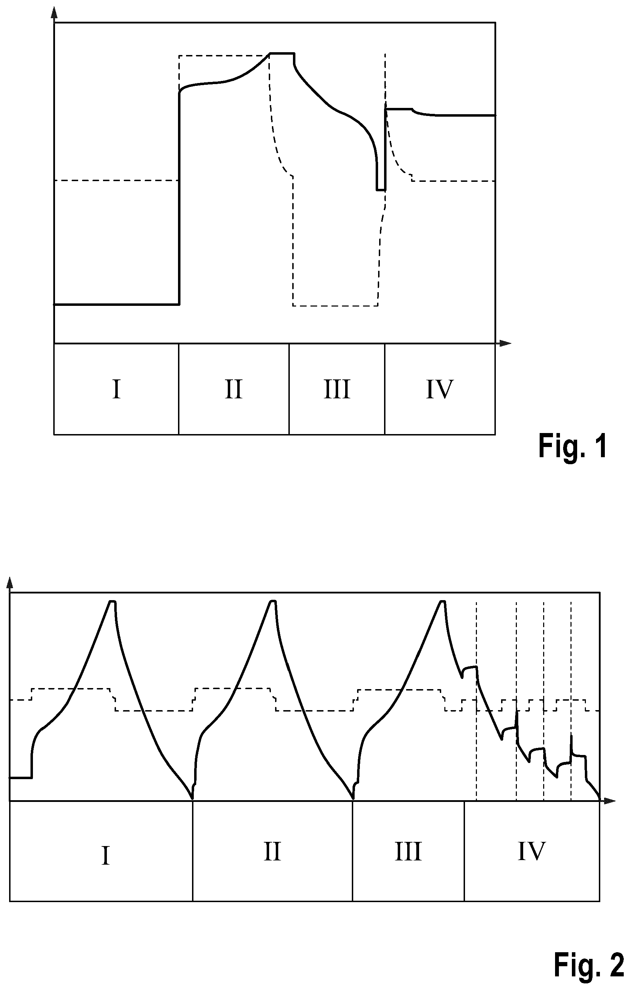

In den Figuren 1 und 2 sind schematische Darstellungen eines Strom-Spannung-Formationsprofils und eines Strom-Spannung-End-of-Life-Profils einer Batteriezelle dargestellt. Die beiden Profile wurden in der Batteriezellenfertigung während der Konditionierung aufgenommen. Genauer gesagt, zeigt Figur 1 das Strom-Spannung-Formationsprofil der Batteriezelle während eines Formationsprozesses und Figur 2 das Strom-Spannung-End-of-Life-Profil der Batteriezelle während eines End-of-Line-Tests. Mithilfe derartiger Profile können jeweils individuelle Informationen und Charakteristiken von gefertigten Batteriezellen sichtbar gemacht werden. Je nach Qualität oder Güte der Batteriezellen, beispielsweise solche mit unzureichender (zu hoher) oder ausreichender (niedriger) Selbstentladerate, treten identifizierbare charakteristische Muster in den Strom-Spannung-Formations- und Strom-Spannung-End-of-Life-Profilen auf, anhand derer die Qualität oder Güte einer zu überprüfenden Batteriezelle bewertet und eine Selbstentladerate vorhergesagt werden kann.

Wie in Figur 1 dargestellt, durchläuft die Batteriezelle in dem Formationsprozess der Batteriezellenfertigung im Wesentlichen vier Abschnitte (I bis IV). Die dargestellten Abschnitte I bis IV sind im zeitlichen Verlauf aufeinander folgend dargestellt, das heißt, auf der nicht näher dargestellten Abszisse in einer Zeitskala von wenigen Stunden, beispielsweise von 4 Stunden, aufgetragen. Der Einfachheit halber beträgt die Zeitdauer für einen jeden Abschnitt I bis IV eine Stunde. Die durchgezogene Linie entspricht einem Verlauf der Spannung der Batteriezelle, welche im ersten Abschnitt I minimal, also nahezu null ist. Mit anderen Worten ist die mechanisch zusammengebaute Batteriezelle im Abschnitt I (noch) elektrisch inaktiv. Die gestrichelt dargestellte Linie zeigt einen Verlauf der Stromstärke, die im ersten Abschnitt I null Ampère (0 A) beträgt. Das Niveau der Spannung der Batteriezelle im inaktiven Zustand kann von Batteriezelle zu Batteriezelle individuell variieren und somit einen zusätzlichen Prozessparameter bei der Bestimmung der Selbstentladerate der Batteriezelle darstellen.

Mit dem Beginn des zweiten Abschnitts II wird die Batteriezelle erstmalig elektrisch aktiviert. Hierzu wird die Batteriezelle mit einer konstant hohen Stromstärke von beispielsweise 75 Ampere versorgt (sogenannte Constant Current Phase). Nachdem sich die für die Funktion der Batteriezelle relevanten Deckschichten mittels chemisch irreversibler Prozesse auf den Elektroden ausgebildet haben, erreicht die Spannung der Batteriezelle mittels eines für die individuelle Batteriezelle charakteristischen Verlaufs ein Maximum, beispielsweise von 4,2 Volt. Nach Erreichen des Spannungsmaximums wird die Spannung der Batteriezelle auf dem Spannungsmaximum konstant gehalten und die Charakteristik der individuellen Batteriezelle anhand abfließender Ladungsträger, also der Stromstärke, erfasst (sogenannte Constant Voltage Phase). Die Ladedauer zum Erreichen des Spannungsmaximums und die Dauer zum Erreichen eines Stromstillstands unter konstanter Spannung (Stromstärke von null Ampere) können von Batteriezelle zu Batteriezelle individuell variieren und somit jeweils einen zusätzlichen Prozessparameter bei der Bestimmung der Selbstentladerate der Batteriezelle darstellen.

In dem dritten Abschnitt III wird die Batteriezelle mit einer konstanten Stromstärke, beispielsweise von -75 A, entladen, beispielsweise bis auf eine Spannung von 2,1 Volt, und die charakteristische Entladungskurve der individuellen Batteriezelle anhand der Spannung aufgezeichnet (erneute Constant Current Phase). Im Anschluss wird die Spannung konstant gehalten und ein charakteristischer Verlauf der Stromstärke der individuellen Batteriezelle erfasst (erneute Constant Voltage Phase). In dieser Phase kann vor allem eine Entladeenergie, also eine Ladungsmenge, der Batteriezelle bestimmt werden. Hierdurch kann ein Wirkungsgrad (Ladewirkungsgrad, coulombscher Wirkungsgrad, auch coulombsche Effizienz) der Batteriezelle ermittelt werden, welcher nicht mit dem Wirkungsgrad der Batteriezelle in Lade- und Entladezyklen im späteren Betrieb vergleichbar ist, da während der elektrischen Aktivierung der Batteriezelle noch irreversible chemische Prozesse ablaufen. Der Wirkungsgrad kann von Batteriezelle zu Batteriezelle individuell variieren und somit einen zusätzlichen Prozessparameter bei der Bestimmung der Selbstentladerate der Batteriezelle darstellen.

Im vierten Abschnitt IV folgt ein erneutes kurzes Aufladen der Batterie auf ein Spannungsniveau, welches einem Entladezustand der Batteriezelle im späteren Betrieb entspricht, genauer auf 3,2 V, mit anschließender Relaxation der Batteriezelle. Die Relaxationsdauern der Batteriezelle können von Batteriezelle zu Batteriezelle individuell variieren und somit einen zusätzlichen Prozessparameter bei der Bestimmung der Selbstentladerate der Batteriezelle darstellen.

Mit dem in Figur 2 gezeigten Strom-Spannung-End-of-Life-Profil wird eine elektrochemische Qualität der Batteriezelle überprüft. Der hierzu durchgeführte End-of-Line-Test ist beispielhaft in vier (weitere) Abschnitte V. bis VIII aufgegliedert (s. Figur 2). Die Abschnitte V bis VIII werden mit fortlaufenden römischen Zahlen gekennzeichnet, da der End-of-Line-Test bevorzugt nahtlos an den Formationsprozess anschließt, um die Produktionszeit möglichst zu verringern.

Die gestrichelt in Figur 2 dargestellte Kurve veranschaulicht einen zeitlichen Verlauf der Stromstärke und die durchgezogene Kurve einen entsprechenden zeitlichen Verlauf der Spannung. Der zeitliche Verlauf beträgt beispielsweise 20 Stunden, sodass die beiden in den Abschnitten V und VI dargestellten Auf- und Entladezyklen jeweils 6 Stunden andauern, während der Auf- und Entladezyklus in Abschnitt VII und Abschnitt VIII beispielhaft mit einer Dauer von 8 Stunden, davon jeweils 4 Stunden pro Abschnitt, abgebildet ist.

Die Abschnitte V bis VII umfassen jeweils einen Auf- und Entladevorgang der Batteriezelle mit einer Stromstärke von 25 A (Entladung -25A). Die Spannung der Batteriezelle pendelt zwischen 3,1 Volt im Minimum und 4,2 Volt im Maximum. Im Abschnitt VIII, welcher während der Entladung der Batteriezelle im Abschnitt VII einsetzt, wird ein Innenwiderstand der Batteriezelle bei verschiedenen Ladungszuständen bezogen auf einen vollständigen Auf- (100%) und Entladezustand (0%) der Batteriezelle, beispielsweise bei 80%, 50%, 35% und 20% Ladezustand, ermittelt, um die von den Ladezuständen abhängigen, das heißt variierenden, Innenwiderstände über den gesamten späteren Betriebsbereich der Batteriezelle zu kontrollieren. Neben den charakteristischen Auf- und Entladungskurven bieten auch die ermittelten Innenwiderstände der Batteriezelle individuelle Informationen, die in Verbindung mit ausreichenden oder unzureichenden Selbstentladungsraten gesetzt und bei der Vorhersage der Selbstentladungsrate einer zu überprüfenden Batteriezelle verwendet werden können. Zu beachten ist, dass der Abschnitt VIII zur Bestimmung der Innenwiderstände der Batteriezellen optional ist und der End-of-Line-Test auch ohne diese Bestimmung erfolgen kann.

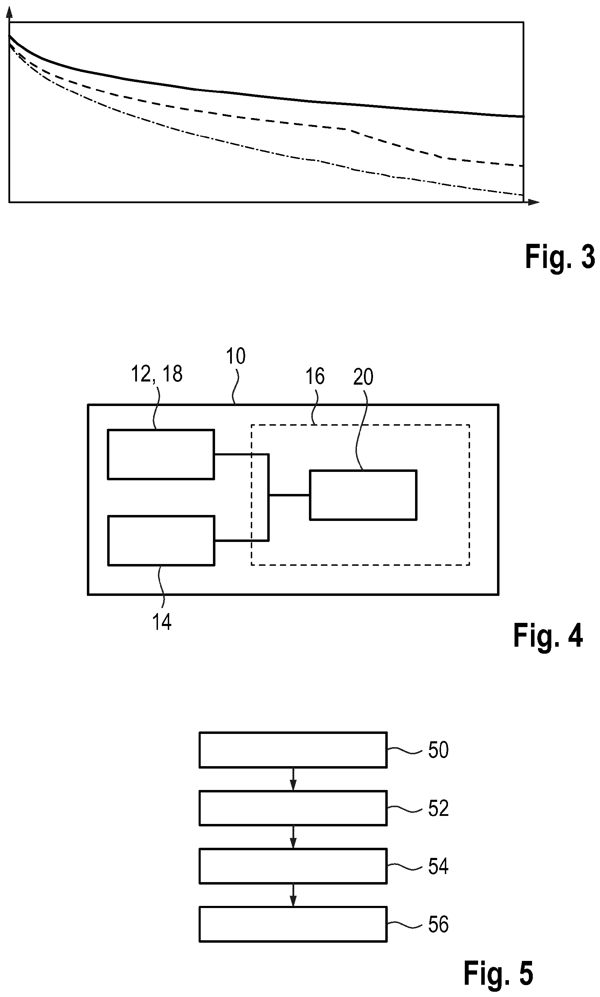

Figur 3 zeigt eine schematische Darstellung von drei verschiedenen Selbstentladungs-Profilen von Batteriezellen im zeitlichen Verlauf, welche während der Reifelagerung messtechnisch bestimmt wurden. Die Selbstentladungs-Profile sind über eine Zeitskala von 0 Tagen (links) bis 6 Tagen (rechts) und einer Spannung beginnend bei beispielhaft 4,15 Volt und abfallend auf eine Spannung am sechsten Tag nach der Aufladung von 4,11V für die durchgezogene Kurve (obere Kurve), 4,09 V für die gestrichelte Kurve (mittlere Kurve) und 4,08 Volt für die gestrichpunktete Kurve (untere Kurve). Auf Basis des Spannungsabfalls kann aus dem Selbstentladungs-Profil eine Selbstentladungsrate der Batteriezelle zu einem vorbestimmten Tag nach der Aufladung der Batteriezelle, beispielsweise, wie für die Reifelagerung üblich, nach 14 bis 21 Tagen, bestimmt, mithin extrapoliert, werden.

Das Selbstentladungs-Profil der durchgezogenen Kurve soll anschaulich einer intakten Batteriezelle entsprechen, also einer Batteriezelle, welche sich für den Verkauf eignet und eine ausreichend geringe Selbstentladerate aufweist. Die Selbstentladungs-Profile der gestrichelten und gestrichpunkteten Kurve stellen beispielhaft mangel- oder fehlerhafte Batteriezellen dar, welche sich nicht für den Verkauf eignen und eine zu hohe Selbstentladerate aufweisen. Die gestrichelte Kurve weist zudem einen Knick im Verlauf auf, welche auf einen Fertigungsfehler der Batteriezelle hinweisen, während die Batteriezelle gemäß der gestrichpunkteten Kurve einen zu großen Spannungsverlust erleidet.

Die zu den Batteriezellen der in Figur 3 beispielhaft gezeigten Selbstentladeraten zugehörigen Strom-Spannung-Formations- und Strom-Spannung-End-of-Life-Profile werden als korrespondierende Strom-Spannungs-Profil-Selbstentladerate-Paarung abspeichert und dienen als Grundlage zur erfindungsgemäßen Bestimmung der Selbstentladerate einer zu überprüfenden Batteriezelle. Verständlich ist, dass die Vorhersagequalität mit steigender Anzahl von Profil-Selbstentladerate-Paarungen oder unter Betrachtung weiterer Prozessparameter, wie der vorgestellten Bestimmung des Innenwiderstands der Batteriezelle, verbessert wird.

Figur 4 zeigt eine schematische Darstellung einer Vorrichtung 10 gemäß einer Ausführungsform. Die Vorrichtung 10 ist zum Abschätzen einer Selbstentladerate einer Batteriezelle aus der Batteriezellenfertigung geeignet. Die Vorrichtung 10 umfasst eine zum Aufnehmen eines Strom-Spannung-Formationsprofils einer Batteriezelle während eines Formationsprozesses eingerichtete Sensoreinheit 12 (siehe Figur 1). Die Sensoreinheit 12 und/oder eine weitere Sensoreinheit 18 sind außerdem dazu eingerichtet, ein Strom-Spannung-End-of-Life-Profil der Batteriezelle während eines End-of-Line-Tests in der Batteriezellenfertigung aufzunehmen (siehe Figur 2).

Die Vorrichtung 10 umfasst ferner eine Speichereinheit 14 mit einer hinterlegten Vielzahl von Strom-Spannung-Formationsprofilen, einer zugehörigen Vielzahl von Strom-Spannung-End-of-Life-Profilen und korrespondierenden Selbstentladeraten oder Selbstentladungs-Profilen einer Vielzahl von Batteriezellen aus der Batteriezellenfertigung (siehe Figur 3).

Ferner umfasst die Vorrichtung 10 eine Steuereinheit 16, die dazu eingerichtet ist, eine Selbstentladerate der Batteriezelle unter Verwendung des Strom-Spannung-Formations- und des Strom-Spannung-End-of-Life-Profils der Batteriezelle und der in der Speichereinheit 14 hinterlegten Vielzahl von Strom-Spannung-Formations- und Strom-Spannung-End-of-Life-Profilen und korrespondierenden Selbstentladeraten oder Selbstentladungs-Profilen der Vielzahl von Batteriezellen aus der Batteriezellenfertigung zu bestimmen.

Die Steuereinheit 16 umfasst ein neuronales Netzwerk 20, welches mittels Trainingsdaten, die die in der Speichereinheit 14 hinterlegte Vielzahl von Strom-Spannung-Formations- und Strom-Spannung-End-of-Life-Profilen und die korrespondierenden Selbstentladeraten der Vielzahl von Batteriezellen aus der Batteriezellenfertigung umfassen, trainiert. Das neuronale Netzwerk 20 ermöglicht vorteilhaft, auch kleinste charakteristische Muster in den Strom-Spannung-Formations- und Strom-Spannung-End-of-Life-Profilen zu erkennen und diese bekannten Strom-Spannung-Formations- und Strom-Spannung-End-of-Life-Profil zuzuordnen. Die Mustererkennung des neuronalen Netzwerkes 20 dient dann der Vorhersage einer Selbstentladungsrate und/oder eines Selbstentladungs-Profils der zu überprüfenden Batteriezelle.

Vorteilhaft ist der erste Sensor 12 und/oder der weitere Sensor 18 dazu eingerichtet, ein Selbstentladungs-Profil der Batteriezelle während eines Reifelagerungsprozesses in der Batteriezellenfertigung aufzunehmen. Dann ist die Steuereinheit 16, insbesondere das neuronale Netzwerk 20, dazu eingerichtet, die Selbstentladerate der Batteriezelle ferner unter Verwendung des Selbstentladungs-Profils der Batteriezelle zu bestimmen. Durch die zusätzliche Verwendung von messtechnisch bestimmten Selbstentladeprofilen zur Bestimmung der Selbstladerate wird die Vorhersagequalität verbessert. Das Selbstentladungs-Profil wird hierbei über einen kleineren Zeitraum, beispielsweise den in Figur 3 gezeigten zeitlichen Verlauf von 6 Tagen, aufgenommen als bei der regulär vorgesehenen Reifelagerung, 14 bis 21 Tage. Dadurch kann zumindest ein Großteil der Dauer der Reifelagerung eingespart werden.

Figur 5 zeigt eine schematische Darstellung eines Verfahrens gemäß einer Durchführungsform. Das Verfahren ist zum Abschätzen einer Selbstentladerate einer Batteriezelle in der Batteriezellenfertigung geeignet.

In einem ersten Verfahrensschritt 50 wird ein mittels Trainingsdaten, die eine Vielzahl von Strom-Spannung-Formations- und Strom-Spannung-End-of-Life-Profilen und korrespondierende Selbstentladeraten einer Vielzahl von Batteriezellen aus der Batteriezellenfertigung umfassen, trainiertes neuronales Netzwerk 20 bereitgestellt.

In einem weiteren Verfahrensschritt 52 wird ein Strom-Spannung-Formationsprofils einer zu überprüfenden Batteriezelle während eines Formationsprozesses in der Batteriezellenfertigung aufgenommen.

In Verfahrensschritt 54 wird ein Strom-Spannung-End-of-Life-Profil der Batteriezelle während eines End-of-Line-Tests in der Batteriezellenfertigung aufgenommen.

In dem vierten Verfahrensschritt 56 wird eine Selbstentladerate und/oder ein Selbstentladungs-Profil der zu überprüfenden Batteriezelle unter Verwendung des Strom-Spannung-Formations- und Strom-Spannung-End-of-Life-Profils der Batteriezelle und des trainierten neuronalen Netzwerkes 20 bestimmt. Hierbei wird die Mustererkennung des neuronalen Netzwerkes 20 ausgenutzt, um kleinste individuelle Charakteristiken der individuellen Batteriezellen zu identifizieren.

### Bezugszeichenliste

- 10: Vorrichtung zum Abschätzen einer Selbstentladerate einer Batteriezelle in der Batteriezellenfertigung
- 12: Sensoreinheit
- 14: Speichereinheit
- 16: Steuereinheit
- 18: weitere Sensoreinheit
- 20: neuronales Netzwerk
- 50: Erster Verfahrensschritt
- 52: Zweiter Verfahrensschritt
- 54: Dritter Verfahrensschritt
- 56: Vierter Verfahrensschritt

## Patentansprüche

1. Verfahren zum Abschätzen einer Selbstentladerate einer Batteriezelle in der Batteriezellenfertigung, umfassend die Schritte:
Aufnehmen eines Strom-Spannung-Formationsprofils einer Batteriezelle während eines Formationsprozesses in der Batteriezellenfertigung,
Bestimmen einer Selbstentladerate der Batteriezelle unter Verwendung des Strom-Spannung-Formationsprofils der Batteriezelle und einer Vielzahl von Strom-Spannung-Formationsprofilen und korrespondierenden Selbstentladeraten oder Selbstentladungs-Profilen einer Vielzahl von Batteriezellen aus der Batteriezellenfertigung.

2. Verfahren nach Anspruch 1, ferner umfassend den Schritt:
Aufnehmen eines Strom-Spannung-End-of-Life-Profils der Batteriezelle während eines End-of-Line-Tests in der Batteriezellenfertigung, wobei das Bestimmen der Selbstentladerate der Batteriezelle ferner unter Verwendung des Strom-Spannung-End-of-Life-Profils der Batteriezelle und einer Vielzahl von Strom-Spannung-End-of-Life-Profilen der Vielzahl von Batteriezellen aus der Batteriezellenfertigung erfolgt.

3. Verfahren nach einem der vorangehenden Ansprüche, wobei die Selbstentladerate der Batteriezelle unter Verwendung eines neuronalen Netzwerks (18) bestimmt wird, wobei das neuronale Netzwerk (18) mittels Trainingsdaten trainiert ist und die Trainingsdaten die Vielzahl von Strom-Spannung-Formationsprofilen, Strom-Spannung-End-of-Life-Profilen und/oder korrespondierenden Selbstentladeraten der Vielzahl von Batteriezellen aus der Batteriezellenfertigung umfassen.

4. Verfahren nach einem der vorangehenden Ansprüche, wobei ein Abschätzungsfehler zu der bestimmten Selbstentladerate der Batteriezelle ermittelt wird und basierend auf dem ermittelten Abschätzungsfehler das Bestimmen der Selbstentladerate der Batteriezelle ferner unter Verwendung eines zusätzlichen Prozessparameters der Batteriezelle erneut erfolgt.

5. Verfahren nach einem der vorangehenden Ansprüche, ferner umfassend den Schritt:
Aufnehmen eines Selbstentladungs-Profils der Batteriezelle während eines Reifelagerungsprozesses in der Batteriezellenfertigung, wobei das Bestimmen der Selbstentladerate der Batteriezelle ferner unter Verwendung des Selbstentladungs-Profils der Batteriezelle und einer Vielzahl von Selbstentladungs-Profilen der Vielzahl von Batteriezellen aus der Batteriezellenfertigung erfolgt.

6. Vorrichtung (10) zum Abschätzen einer Selbstentladerate einer Batteriezelle aus der Batteriezellenfertigung, umfassend:
eine Sensoreinheit (12), die zum Aufnehmen eines Strom-Spannung-Formationsprofils einer Batteriezelle während eines Formationsprozesses in der Batteriezellenfertigung eingerichtet ist,
eine Speichereinheit (14) mit einer hinterlegten Vielzahl von Strom-Spannung-Formationsprofilen und korrespondierenden Selbstentladeraten oder Selbstentladungs-Profilen einer Vielzahl von Batteriezellen aus der Batteriezellenfertigung und
eine Steuereinheit (16), die dazu eingerichtet ist, eine Selbstentladerate der Batteriezelle unter Verwendung des Strom-Spannung-Formationsprofils der Batteriezelle und der in der Speichereinheit (14) hinterlegten Vielzahl von Strom-Spannung-Formationsprofilen und korrespondierenden Selbstentladeraten oder Selbstentladungs-Profilen der Vielzahl von Batteriezellen aus der Batteriezellenfertigung zu bestimmen.

7. Vorrichtung (10) nach Anspruch 6, wobei die Sensoreinheit (12) und/oder eine weitere Sensoreinheit (18), zum Aufnehmen eines Strom-Spannung-End-of-Life-Profils der Batteriezelle während eines End-of-Line-Tests in der Batteriezellenfertigung eingerichtet ist, in der Speichereinheit (14) ferner eine Vielzahl von Strom-Spannung-End-of-Life-Profilen der Vielzahl von Batteriezellen aus der Batteriezellenfertigung hinterlegt ist, und die Steuereinheit (16) ferner dazu eingerichtet ist, die Selbstentladerate der Batteriezelle ferner unter Verwendung des Strom-Spannung-End-of-Life-Profils der Batteriezelle und der in der Speichereinheit (14) hinterlegten Vielzahl von Strom-Spannung-End-of-Life-Profilen der Vielzahl von Batteriezellen aus der Batteriezellenfertigung zu bestimmen.

8. Vorrichtung (10) nach Anspruch 6 oder 7, wobei die Steuereinheit (16) ein neuronales Netzwerk (20) umfasst, wobei das neuronale Netzwerk (20) mittels Trainingsdaten trainiert ist und die Trainingsdaten die Vielzahl von Strom-Spannung-Formationsprofilen, Strom-Spannung-End-of-Life-Profilen und/oder korrespondierenden Selbstentladeraten der Vielzahl von Batteriezellen aus der Batteriezellenfertigung umfassen, wobei die Steuereinheit (16) dazu eingerichtet ist, die Selbstentladerate der Batteriezelle unter Verwendung des neuronalen Netzwerks (20) zu bestimmen.

9. Vorrichtung (10) nach einem der Ansprüche 6 bis 8, wobei die Steuereinheit (16) ferner dazu eingerichtet ist, einen Abschätzungsfehler zu der bestimmten Selbstentladerate der Batteriezelle zu ermitteln und basierend auf dem ermittelten Abschätzungsfehler die Selbstentladerate der Batteriezelle ferner unter Verwendung eines zusätzlichen Prozessparameters der Batteriezelle erneut zu bestimmen.

10. Vorrichtung (10) nach einem der Ansprüche 6 bis 9, wobei die erste Sensoreinheit (12) und/oder eine weitere Sensoreinheit (18) zum Aufnehmen eines Selbstentladungs-Profils der Batteriezelle während eines Reifelagerungsprozesses in der Batteriezellenfertigung eingerichtet ist, in der Speichereinheit (14) ferner eine Vielzahl von Selbstentladungs-Profilen der Vielzahl von Batteriezellen aus der Batteriezellenfertigung hinterlegt sind, und wobei die Steuereinheit (16) ferner dazu eingerichtet ist, die Selbstentladerate der Batteriezelle ferner unter Verwendung des Selbstentladungs-Profils der Batteriezelle und der in der Speichereinheit (14) hinterlegten Vielzahl von Selbstentladungs-Profilen der Vielzahl von Batteriezellen aus der Batteriezellenfertigung zu bestimmen.

## Claims

1. Method for estimating a self-discharge rate of a battery cell in battery cell production, comprising the steps of:
recording a current-voltage formation profile of a battery cell during a formation process in battery cell production,
determining a self-discharge rate of the battery cell using the current-voltage formation profile of the battery cell and a plurality of current-voltage formation profiles and corresponding self-discharge rates or self-discharge profiles of a plurality of battery cells from battery cell production.

2. Method according to claim 1, further comprising the step of:
recording a current-voltage end-of-life profile of the battery cell during an end-of-line test in battery cell production, wherein the self-discharge rate of the battery cell is further determined using the current-voltage end-of-life profile of the battery cell and a plurality of current-voltage end-of-life profiles of the plurality of battery cells from battery cell production.

3. Method according to either of the preceding claims, wherein the self-discharge rate of the battery cell is determined using a neural network (18), wherein the neural network (18) is trained using training data and the training data comprise the plurality of current-voltage formation profiles, current-voltage end-of-life profiles and/or corresponding self-discharge rates of the plurality of battery cells from battery cell production.

4. Method according to any of the preceding claims, wherein an estimation error regarding the determined self-discharge rate of the battery cell is ascertained and, on the basis of the ascertained estimation error, the self-discharge rate of the battery cell is further determined again using an additional process parameter of the battery cell.

5. Method according to any of the preceding claims, further comprising the step of:
recording a self-discharge profile of the battery cell during an aging storage process in battery cell production, wherein the self-discharge rate of the battery cell is further determined using the self-discharge profile of the battery cell and a plurality of self-discharge profiles of the plurality of battery cells from battery cell production.

6. Device (10) for estimating a self-discharge rate of a battery cell from battery cell production, comprising:
a sensor unit (12) which is designed to record a current-voltage formation profile of a battery cell during a formation process in battery cell production,
a storage unit (14) having a stored plurality of current-voltage formation profiles and corresponding self-discharge rates or self-discharge profiles of a plurality of battery cells from battery cell production and
a control unit (16) which is designed to determine a self-discharge rate of the battery cell using the current-voltage formation profile of the battery cell and the plurality of current-voltage formation profiles and corresponding self-discharge rates or self-discharge profiles of the plurality of battery cells from battery cell production which are stored in the storage unit (14).

7. Device (10) according to claim 6, wherein the sensor unit (12) and/or a further sensor unit (18) is designed to record a current-voltage end-of-life profile of the battery cell during an end-of-line test in battery cell production, and a plurality of current-voltage end-of-life profiles of the plurality of battery cells from battery cell production are further stored in the storage unit (14), and the control unit (16) is further designed to determine the self-discharge rate of the battery cell using the current-voltage end-of-life profile of the battery cell and the plurality of current-voltage end-of-life profiles of the plurality of battery cells from battery cell production which are stored in the storage unit (14).

8. Device (10) according to claim 6 or 7, wherein the control unit (16) comprises a neural network (20), wherein the neural network (20) is trained using training data and the training data comprise the plurality of current-voltage formation profiles, current-voltage end-of-life profiles and/or corresponding self-discharge rates of the plurality of battery cells from battery cell production, wherein the control unit (16) is designed to determine the self-discharge rate of the battery cell using the neural network (20).

9. Device (10) according to any of claims 6 to 8, wherein the control unit (16) is further designed to ascertain an estimation error regarding the determined self-discharge rate of the battery cell and, on the basis of the ascertained estimation error, to further determine the self-discharge rate of the battery cell again using an additional process parameter of the battery cell.

10. Device (10) according to any of claims 6 to 9, wherein the first sensor unit (12) and/or a further sensor unit (18) is designed to record a self-discharge profile of the battery cell during an aging storage process in battery cell production, and a plurality of self-discharge profiles of the plurality of battery cells from battery cell production are further stored in the storage unit (14), and wherein the control unit (16) is further designed to further determine the self-discharge rate of the battery cell using the self-discharge profile of the battery cell and the plurality of self-discharge profiles of the plurality of battery cells from battery cell production which are stored in the storage unit (14).

## Revendications

1. Procédé pour l'estimation d'un taux de décharge spontanée d'un élément de batterie dans le cadre de la fabrication d'éléments de batterie, comprenant les étapes consistant à :
enregistrer un profil courant-tension de formation d'un élément de batterie pendant un processus de formation dans le cadre de la fabrication d'éléments de batterie,
déterminer un taux de décharge spontanée d'un élément de batterie à l'aide du profil courant-tension de formation de l'élément de batterie et d'une pluralité de profils courant-tension de formation et de taux de décharge spontanée correspondants ou de profils de décharge spontanée d'une pluralité d'éléments de batterie provenant de la fabrication d'éléments de batterie.

2. Procédé selon la revendication 1, comprenant en outre l'étape consistant à :
enregistrer un profil courant-tension de fin de vie utile de l'élément de batterie pendant un essai de fin de ligne dans le cadre de la fabrication d'éléments de batterie, dans lequel la détermination du taux de décharge spontanée de l'élément de batterie est en outre effectuée à l'aide du profil courant-tension de fin de vie utile de l'élément de batterie et d'une pluralité de profils courant-tension de fin de vie utile de la pluralité d'éléments de batterie provenant de la fabrication d'éléments de batterie.

3. Procédé selon l'une des revendications précédentes, dans lequel le taux de décharge spontanée de l'élément de batterie est déterminé à l'aide d'un réseau neuronal (18), dans lequel le réseau neuronal (18) est entraîné au moyen de données d'apprentissage, et les données d'apprentissage comprennent la pluralité de profils courant-tension de formation, de profils courant-tension de fin de vie utile et/ou les taux de décharge spontanée correspondant à la pluralité d'éléments de batterie provenant de la fabrication d'éléments de batterie.

4. Procédé selon l'une des revendications précédentes, dans lequel une erreur d'estimation relative au taux de décharge spontanée déterminé de l'élément de batterie est calculée et, sur la base de l'erreur d'estimation calculée, la détermination du taux de décharge spontanée de l'élément de batterie est effectuée à nouveau à l'aide d'un paramètre de processus supplémentaire de l'élément de batterie.

5. Procédé selon l'une des revendications précédentes, comprenant en outre l'étape consistant à :
enregistrer un profil de décharge spontanée de l'élément de batterie pendant un processus de stockage de conditionnement dans le cadre de la fabrication d'éléments de batterie, dans lequel la détermination du taux de décharge spontanée de l'élément de batterie est en outre effectuée à l'aide du profil de décharge spontanée de l'élément de batterie et d'une pluralité de profils de décharge spontanée de la pluralité d'éléments de batterie provenant de la fabrication d'éléments de batterie.

6. Dispositif (10) pour l'estimation d'un taux de décharge spontanée d'un élément de batterie provenant de la fabrication d'éléments de batterie, comprenant :
une unité formant capteur (12) configurée pour enregistrer un profil courant-tension de formation d'un élément de batterie pendant un processus de formation dans le cadre de la fabrication d'éléments de batterie,
une unité formant mémoire (14) comportant une pluralité de profils courant-tension de formation et des taux de décharge spontanée correspondants ou des profils de décharge spontanée d'une pluralité d'éléments de batterie provenant de la fabrication d'éléments de batterie consignés, et
une unité de commande (16) configurée pour déterminer un taux de décharge spontanée de l'élément de batterie à l'aide du profil courant-tension de formation de l'élément de batterie et de la pluralité de profils courant-tension de formation et des taux de décharge spontanée correspondants ou des profils de décharge spontanée de la pluralité d'éléments de batterie provenant de la fabrication d'éléments de batterie consignés dans l'unité formant mémoire (14).

7. Dispositif (10) selon la revendication 6, dans lequel l'unité formant capteur (12) et/ou une autre unité formant capteur (18) configurées pour enregistrer un profil courant-tension de fin de vie utile de l'élément de batterie pendant un essai de fin de ligne dans le cadre de la fabrication d'éléments de batterie, une pluralité de profils courant-tension de fin de vie utile de la pluralité d'éléments de batterie provenant de la fabrication d'éléments de batterie sont en outre consignés dans l'unité formant mémoire (14), et l'unité de commande (16) est en outre configurée pour déterminer le taux de décharge spontanée de l'élément de batterie à l'aide du profil courant-tension de fin de vie utile de l'élément de batterie et de la pluralité de profils courant-tension de fin de vie utile de la pluralité d'éléments de batterie provenant de la fabrication d'éléments de batterie consignés dans l'unité formant mémoire (14).

8. Dispositif (10) selon la revendication 6 ou 7, dans lequel l'unité de commande (16) comprend un réseau neuronal (20), dans lequel le réseau neuronal (20) est entraîné au moyen de données d'apprentissage et les données d'apprentissage comprennent la pluralité de profils courant-tension de formation, de profils courant-tension de fin de vie utile et/ou les taux de décharge spontanée correspondant à la pluralité d'éléments de batterie provenant de la fabrication d'éléments de batterie, dans lequel l'unité de commande (16) est configurée pour déterminer le taux de décharge spontanée de l'élément de batterie à l'aide du réseau neuronal (20).

9. Dispositif (10) selon l'une des revendications 6 à 8, dans lequel l'unité de commande (16) est en outre configurée pour calculer une erreur d'estimation relative au taux de décharge spontanée déterminé de l'élément de batterie et, sur la base de l'erreur d'estimation calculée, pour déterminer à nouveau le taux de décharge spontanée de l'élément de batterie à l'aide, en outre, d'un paramètre de processus supplémentaire de l'élément de batterie.

10. Dispositif (10) selon l'une des revendications 6 à 9, dans lequel la première unité formant capteur (12) et/ou une autre unité formant capteur (18) sont configurées pour enregistrer un profil de décharge spontanée de l'élément de batterie pendant un processus de stockage de conditionnement dans le cadre de la fabrication d'éléments de batterie, une pluralité de profils de décharge spontanée de la pluralité d'éléments de batterie provenant de la fabrication d'éléments de batterie sont en outre consignés dans l'unité formant mémoire (14), et dans lequel l'unité de commande (16) est en outre configurée pour déterminer le taux de décharge spontanée de l'élément de batterie à l'aide, en outre, du profil de décharge spontanée de l'élément de batterie et de la pluralité de profils de décharge spontanée de la pluralité d'éléments de batterie provenant de la fabrication d'éléments de batterie consignés dans l'unité formant mémoire (14).
